# EUROPÄISCHE PATENTSCHRIFT

(11) **EP 0 408 797 B1**
(45) Veröffentlichungstag und Bekanntmachung des Hinweises auf die Patenterteilung: **26.01.1994**
(21) Anmeldenummer: 89113373.8
(22) Anmeldetag: 20.07.1989
(51) Int. Cl.: H04Q 3/52, H03K 19/094

(54) **Breitbandsignal-Koppeleinrichtung**
Coupling device for broadband signals
Dispositif de couplage pour signaux large bande

(43) Veröffentlichungstag der Anmeldung: 23.01.1991
(73) Patentinhaber: SIEMENS AKTIENGESELLSCHAFT, 80333 München (DE)
(72) Erfinder: Trumpp, Gerhard, Dipl,-Ing., D-8039 Puchheim (DE); Wolkenhauer, Jan, Dipl,-Ing., D-8000 München 70 (DE)

(56) Entgegenhaltungen:
- EP-A- 0 103 236
- EP-A- 0 219 701
- EP-A- 0 262 479
- PATENT ABSTRACTS OF JAPAN, Band 9, Nr. 302 (E-362)[2025], 29. November 1985 & JP-A-60 139 020
- PATENT ABSTRACTS OF JAPAN, Band 8, Nr. 261 (E-281)[1698], 30. November 1984 & JP-A-59 131 221

## Beschreibung

Moderne Entwicklungen der Fernmeldetechnik führen zu diensteintegrierenden Nachrichtenübertragungs- und -vermittlungssystemen für Schmalband- und Breitband-Kommunikationsdienste, die als Übertragungsmedium im Bereich der Teilnehmeranschlußleitungen Lichtwellenleiter vorsehen, über die sowohl die Schmalband-kommunikationsdienste, wie insbesondere 64-kbit/s-Digital-Telefonie, als auch Breitbandkommunikationsdienste, wie insbesondere 140-Mbit/s-Bildtelefonie, geführt werden, wobei in den Vermittlungsstellen auch (vorzuzgsweise gemeinsame Steuereinrichtungen aufweisende) Schmalbandsignal-Koppeleinrichtungen und Breitbandsignal-Koppeleinrichtungen nebeneinander vorgesehen sein können (DE-PS 24 21 002).

Eine (z.B. aus EP-A1-0 262 479) bekannte Breitbandsignal-Koppeleinrichtung weist eine Koppelpunktmatrix in FET-Technik auf, deren Koppelelemente jeweils mit einem an seiner Steuerelektrode mit einem Durchschalte- bzw. Sperrsignal beaufschlagten, mit einer Hauptelektrode an die zugehörige Matrixausgangsleitung angeschlossenen Schalter-Transistor gebildet sind, wobei die Koppelelemente jeweils einen mit dem Schalter-Transistor eine Serienschaltung bildenden Vorschalt-Transistor aufweisen, der mit seiner Steuerelektrode an die zugehörige Matrixeingangsleitung angeschlossen ist und dessen der Serienschaltung abgewandte Hauptelektrode über einen Abtast-Transistor mit dem einen Anschluß der Betriebsspannungsquelle verbunden ist, mit deren anderen Anschluß die jeweilige Matrixausgangsleitung über einen Vorlade-Transistor verbunden ist, und wobei Vorlade-Transistor und Abtast-Transistor gegensinnig zueinander jeweils an ihrer Steuerelektrode mit einem eine Bit-Durchschaltezeitspanne in eine Vorladephase und die eigentliche Durchschaltephase unterteilenden Koppelfeld-Ansteuer-Takt beaufschlagt sind, so daß in jeder Vorphase bei gesperrtem Abtast-Transistor die Matrixausgangsleitung über den Vorlade-Transistor zumindest angenähert auf das an dem genannten anderen Anschluß der Betriebsspannungsquelle herrschende Potential geladen wird. Diese bekannte Breitbandsignal-Koppeleinrichtung, die koppelelement-individuelle Abtasttransistoren oder matrixeingangsleitungs- oder matrixausgangsleitungs-individuelle Abtast-Transistoren aufweisen kann, benötigt zur Ansteuerung dieser Abtast-Transistoren eigene, die Koppelpunktmatrix durchziehende Taktleitungen, was einen entsprechenden Flächenbedarf erfordert und eine entsprechende kapazitive Belastung der Matrixausgangsleitungen mit sich bringt; Taktverteilung und Kopplungen zwischen Matrixeingangsleitungen und Matrixausgangsleitungen erfordern zur Gewährleistung einer ausreichenden Störsicherheit ausreichend große Signalamplituden auf den Matrixausgangsleitungen, was mit einem relativ hohen Leistungsverbrauch verbunden ist.

In der europäischen Patentanmeldung EP-A-0 354 254 ist schon eine Breitbandsignal-Koppeleinrichtung mit einer Koppelpunkt-Matrix in FET-Technik,
deren Eingänge jeweils mit einer Eingangstreiberschaltung versehen sein können,
deren Ausgänge jeweils mit einer Ausgangsverstärkerschaltung versehen sind
deren jeweils von einer Halte-Speicherzelle gesteuerten Koppelelemente jeweils mit einer Serienschaltung eines an seiner Steuerelektrode mit einem Durchschalte- bzw. Sperrsignal beaufschlagten Schalter-Transistors und eines mit seiner Steuerelektrode an die zugehörige Matrixeingangsleitung angeschlossenen Eingangs- Transistors gebildet sind, die mit der der Serienschaltung abgewandten Hauptelektrode des einen Transistors an die zugehörige Matrixausgangsleitung angeschlossen ist,
und bei der die Matrixausgangsleitung mit einer Vorladepotentialquelle über eine Vorladeschaltung verbunden ist, die mit einem Entriegelungseingang an die Taktsignalleitung eines die Vorladephase einer in eine solche Vorladephase und die übrige Bit- Durchschaltezeitspanne unterteilten Bit-Durchschaltezeitspanne definierenden Vorladetaktsignals angeschlossen ist, so daß die Matrixausgangsleitung in jeder Vorladephase auf ein Vorladepotential geladen wird,
vorgeschlagen worden, die eine Hubbegrenzung des Signals auf den Ausgangsleitungen der Koppeleinrichtung vorsieht. Dazu ist die der genannten Serienschaltung abgewandte Hauptelektrode des anderen Transistors jedes Koppelelementes mit dem einen Anschluß der Betriebsspannungsquelle über einen an seiner Steuerelektrode mit dem Ausgang einer matrixausgangsleitungs-individuellen Ausgangsverstärkerschaltung verbundenen matrixausgangsleitungs-individuellen Transistor verbunden; bei einer Signalzustandsänderung am Ausgang der Ausgangsverstärkerschaltung wird dieser Transistor gesperrt und damit eine weitere Umladung der Ausgangsleitung vermieden, womit der Signalhub auf der Ausgangsleitung begrenzt wird.

Bei bekannten Breitbandsignal-Koppeleinrichtungen macht es sich nachteilig bemerkbar, daß ein Großteil der erforderlichen Leistung für das Umladen der Eingangsleitungen der Koppelpunktmatrix aufgewandt werden muß.

Die Erfindung stellt sich nun die Aufgabe, eine Breitbandsignal- Koppeleinrichtung mit Begrenzung des Signalhubs auf den Eingangsleitungen anzugeben.

Die Erfindung betrifft eine Breitbandsignal-Koppeleinrichtung mit einer Koppelpunkt-Matrix in FET-Technik, deren Eingänge jeweils mit einer Eingangstreiberschaltung versehen sind und deren Ausgänge jeweils mit einer Ausgangstreiberschaltung versehen sein können, wobei die Matrix-Ausgangsleitungen jeweils über eine Vorladeschaltung, die mit einem eine Bit-Durchschaltzeitspanne in eine Vorladephase und die eigentliche Durchschaltephase unterteilenden Taktsignal gesteuert wird, in jeder Vorladephase auf ein zwischen den beiden Betriebspotentialen liegendes Vorladepotential oder auch auf eines der beiden Betriebspotentiale selbst aufladbar sind; diese Breitbandsignal-Koppeleinrichtung ist erfindungsgemäß dadurch gekennzeichnet, daß der Ausgang der jeweiligen Eingangstreiberschaltung über ein schwellwertbehaftetes Rückkopplungsglied mit einem Sperreingang der Eingangstreiberschaltung verbunden ist, über den die Umladung des Ausgangs der betreffenden Eingangstreiberschaltung beendet wird.

Die Erfindung bringt den Vorteil einer strikten Begrenzung des Signalhubs auf den Eingangsleitungen mit sich. Die Reduzierung des Signalhubs auf den Eingangsleitungen führt zu einer Verringerung der Umladeverluste, was gleichbedeutend mit einer verringerten Stromaufnahme ist. Mit der verringerten Stromaufnahme geht eine entsprechend verringerte Verlustleistung einher, die eine Erhöhung wahlweise der Packungsdichte von Koppelelementen oder der Schalthäufigkeit erlaubt. Darüber hinaus ergibt sich aus der verringerten Stromaufnahme eine Reduzierung von durch Stromspitzen bedingten Störungen der Betriebsspannung der Breitbandsignal-Koppeleinrichtung. Als zusätzlicher Vorteil ergibt sich durch die Signalhubbegrenzung eine Verringerung von nachteiligen Einflüssen auf benachbarte Signalwege.

In weiterer Ausgestaltung der Erfindung kann die Eingangstreiberschaltung mit einem Inverterverstärker gebildet sein, in dessen einem Betriebsspannungsanschluß ein Transistor eingefügt ist, dessen Steuerelektrode den Sperreingang der Eingangstreiberschaltung bildet. Diese Ausgestaltung erlaubt eine besonders aufwandsarme Ausführung der Eingangstreiberschaltung.

In weiterer Ausgestaltung der Erfindung wird die Eingangstreiberschaltung zweckmäßigerweise in CMOS-Technologie aufgebaut. Durch diese Maßnahme ist die Eingangstreiberschaltung besonders einfach ansteuerbar.

In weiterer Ausgestaltung der Erfindung kann das Rückkopplungsglied mit einer Anzahl von CMOS-Inverterverstärkern gebildet sein. Bei dieser Ausführungsform ist das Rückkopplungsglied in der gleichen Technologie wie die übrige Koppelpunktmatrix ausgeführt und läßt sich deshalb leicht integrieren. Die Schaltschwelle eines solchen mit CMOS-Inverterverstärkern gebildeten Rückkopplungsgliedes hängt von der Schaltschwelle des ersten CMOS-Inverterverstärkers ab und liegt typischerweise bei 40% der das Rückkopplungsglied speisenden Betriebsspannung.

In weiterer Ausgestaltung der Erfindung besteht das Rückkopplungsglied aus zwei CMOS-Inverterverstärkern. Dadurch ist das Ausgangssignal des Rückkopplungsgliedes mit dem Eingangssignal des Rückkopplungsgliedes gleichphasig.

Einer anderen Ausführungsform zufolge kann das Rückkopplungsglied mit einem Komparator gebildet sein, dessen einem Eingang eine Referenzspannung zugeführt wird und dessen anderem Eingang das Ausgangssignal der jeweiligen Eingangstreiberschaltung zugeführt wird. Diese Ausführungsform erlaubt es, die Schwellenspannung auf einen bestimmten Wert festzulegen.

In weiterer Ausgestaltung der Erfindung ist es auch möglich, daß das Rückkopplungsglied seinerseits über einen hochohmigen Widerstand rückgekoppelt ist. Diese Maßnahme erhöht einerseits die Verstärkung im Bereich der Schaltschwelle des Rückkopplungsgliedes und bedingt zum anderen eine kleine Schalthysterese. Beide Wirkungen verbessern das Schaltverhalten des Rückkopplungsgliedes.

Weitere Besonderheiten der Erfindung werden aus der nachfolgenden näheren Erläuterung der Erfindung anhand der Zeichnungen ersichtlich. Dabei zeigen
- FIG 1: das Schema einer erfindungsgemäßen Breitband-Koppeleinrichtung und
- FIG 2 bis FIG 6: Einzelheiten ihrer schaltungstechnischen Realisierung;
- FIG 7: verdeutlicht Signalzustände darin.

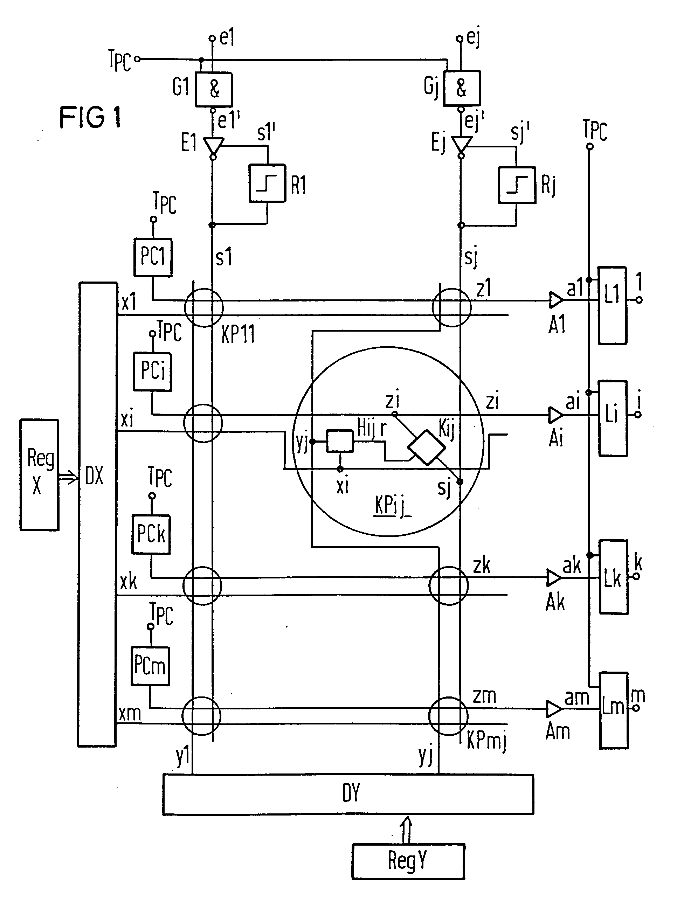

In der Zeichnung FIG 1 ist schematisch in zum Verständnis der Erfindung erforderlichen Umfange eine Breitbandsignal-Koppeleinrichtung skizziert, deren Eingangsleitungen e1...ej jeweils über Torschaltungen G1...Gj, die durch ein ihnen gemeinsames Taktsignal T_{PC} gesteuert werden, und Eingangstreiberschaltungen E1... Ej mit (Matrix-Eingangsleitungen) Spaltenleitungen s1...sj der Koppelpunktmatrix und diese wiederum über spaltenindividuelle Rückkopplungsglieder R1...Rj mit jeweils einem Sperreingang s′ der zugehörigen Eingangstreiberschaltung E verbunden sind.

Die (Matrix-Eingangsleitungen) Zeilenleitungen z1..zm der Koppelpunktmatrix sind einerseits mit zeilenindividuellen Vorladeschaltungen PC1...PCm, die durch ein ihnen gemeinsames Taktsignal T_{PC} gesteuert werden, und andererseits über Ausgangstreiberschaltungen A1...Am mit Haltespeichern (Latches) L1... Lm verbunden, die wiederum durch ein ihnen gemeinsames Taktsignal T_{PC} gesteuert werden.

Die Koppelpunktmatrix weist Koppelpunkte KP11...KPmj auf, deren Koppelelemente, wie dies beim Koppelpunkt KPij für dessen Koppelelement Kij weiter ins Einzelne gehend angedeutet ist, jeweils von einer koppelpunktindividuellen Halte-Speicherzelle Hij (beim Koppelpunkt KPij) gesteuert sein können, deren Ausgang r zum Steuereingang r des jeweiligen Koppelelements (Kij beim Koppelpunkt KPij) führt.

Die Halte-Speicherzellen ... Hij... werden gemäß FIG 1 durch zwei Ansteuerdecoder, nämlich einen Zeilendecoder DX und einen Spaltendecoder DY, über entsprechende Ansteuerleitungen x1...xm; y1...yj in zwei Koordinaten angesteuert.

Dazu mögen, wie dies aus FIG 1 ersichtlich ist, die beiden Ansteuerdecoder DX, DY von Eingangsregistern Reg X, Reg Y her jeweils mit einer einer Matrixreihe (Zeile bzw.Spalte) von Koppelpunkten gemeinsamen Koppelpunktzeilen- bzw. Koppelpunktspalten- Adresse beaufschlagbar sein, auf die hin sie jeweils an der der jeweiligen Koppelpunktreihen-Adresse entsprechenden Ansteuerleitung jeweils ein "1"-Ansteuersignal abgeben. Das Zusammentreffen eines Zeilenansteuersignals "1" und eines Spaltenansteuersignals "1" am Kreuzungspunkt der betreffenden Matrixzeile mit der betreffenden Matrixspalte beim Aufbau einer entsprechenden Verbindung bewirkt dann eine Aktivierung der dort befindlichen Halte- Speicherzelle, beispielsweise der Speicherzelle Hij, mit der Folge, daß das von der betreffenden Halte-Speicherzelle (Hij) gesteuerte Koppelelement, im Beispiel das Koppelelement Kij, leitend wird.

Damit das im Beispiel betrachtete Koppelelement Kij bei einem Abbau der betreffenden Verbindung wieder gesperrt wird, wird wiederum der Ansteuerdecoder DX vom Eingangsregister Reg X mit der betreffenden Zeilenadresse beaufschlagt, so daß der Zeilendecoder DX wiederum auf seiner Ausgangsleitung xi ein Zeilenansteuersignal "1" abgibt, und zugleich wird der Spaltendecoder DY von seinem Eingangsregister Reg Y her beispielsweise mit einer Leeradresse oder mit der Adresse einer Spalte von unbeschalteten Koppelpunkten beaufschlagt, so daß er auf seiner Ausgangsleitung yj ein Spaltenansteuersignal "0" abgibt; das Zusammentreffen von Zeilenansteuersignal "1" und Spaltenansteuersignal "0" bewirkt dann die Rücksetzung der Halte-Speicherzelle Hij mit der Folge, daß das von ihr gesteuerte Koppelelement Kij gesperrt wird.

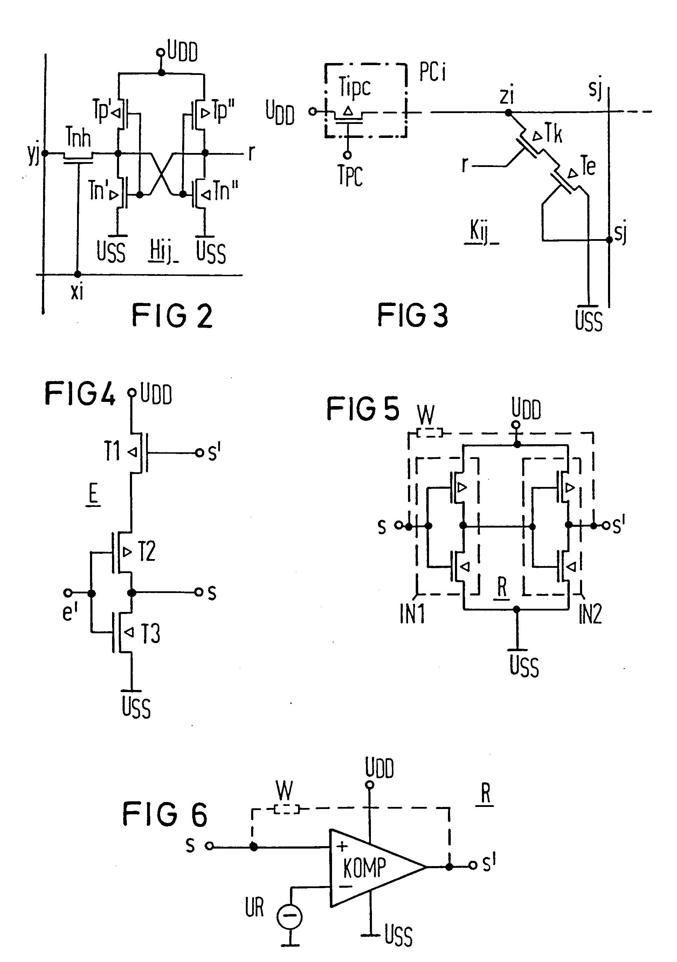

Die Halte-Speicherzellen ...Hij... können in an sich bekannter Weise ausgebildet sein; so können die Halte-Speicherzellen beispielsweise, wie dies z.B. aus EP-A-0 238 834 bekannt und auch in FIG 2 skizziert ist, mit einem n-Kanal-Transistor Tnh und zwei kreuzgekoppelten Inverterschaltungen (CMOS-Inverterschaltungen Tp′, Tn′; Tp˝,Tn˝ gebildet sein, wobei eine Inverterschaltung eingangsseitig mit dem zugehörigen Decoderausgang yj des einen Ansteuerdecoders über den n-Kanal-Transistor Tnh verbunden ist, der seinerseits an seiner Steuerelektrode mit dem Ausgangssignal des zugehörigen Decoderausgangs xi des anderen Ansteuerdecoders beaufschlagt ist, und wobei eine Inverterschaltung ausgangsseitig zum Steuereingang r des zugehörigen Koppelelements führt.

Wie die Koppelelemente ...Kij... schaltungstechnisch realisiert sein können, wird in FIG 3 verdeutlicht: Die Koppelelemente ... Kij... sind jeweils mit einer Serienschaltung eines an seiner Steuerelektrode von der Halte-Speicherzelle her mit einem Durchschalte- bzw. Sperrsignal beaufschlagten Schalter-Transistors Tk und eines mit seiner Steuerelektrode an die zugehörige (Matrixeingangsleitung) Spaltenleitung sj angeschlossenen Eingangs-Transistors Te gebildet, die mit der der Serienschaltung abgewandten Hauptelektrode des einen Transistors Tk an die zugehörige (Matrix-Ausgangsleitung) Zeilenleitung zi angeschlossen ist.

Dabei ist die (Matrix-Ausgangsleitung) Zeilenleitung zi über eine Vorladeschaltung PC mit einer Vorladepotentialquelle verbunden, von der her die (Matrixausgangsleitung) Zeilenleitung zi auf ein zwischen den beiden Betriebspotentialen liegendes Vorladepotential oder auch auf eines der beiden Betriebspotentiale selbst aufladbar ist. Eine Vorladepotentialquelle für ein zwischen den beiden Betriebspotentialen liegendes Vorladepotential kann insbesondere in prinzipiell (z.B. aus EP-A-0 249 837) bekannter Weise mit einem rückgekoppelten CMOS-Inverter gebildet sein, über den jeweils in einer Vorladephase einer Bit-Durchschaltezeitspanne die Zeilenleitung zumindest angenähert auf das der Schaltschwelle des Inverters entsprechende Potential geladen wird. Demgegenüber ist in dem in FIG 3 dargestellten Ausführungsbeispiel die (Matrixausgangsleitung) Zeilenleitung zi mit dem einen Anschluß (U_{DD}) der Betriebsspannungsquelle U_{DD}-U_{SS} über eine Vorladeschaltung verbunden, die, wie dies auch aus FIG 3 ersichtlich ist, in an sich (z.B. aus EP-A-0 262 479) bekannter Weise mit einem mit seiner Steuerelektrode an einer Vorladetaktleitung T_{PC} liegenden Vorlade- Transistor Tipc gebildet ist.

Die der Serienschaltung abgewandte Hauptelektrode des anderen Transistors Te ist kontinuierlich, d.h. nicht taktgesteuert, mit dem anderen Anschluß (U_{SS}, Masse) der Betriebsspannungsquelle U_{DD}- U_{SS} verbunden.

Wie die Eingangstreiberschaltungen E1...Ej schaltungstechnisch realisiert sein können, wird in FIG 4 verdeutlicht: Die Eingangstreiberschaltung E gemäß FIG 4 ist mit einem CMOS-Inverterverstärker, gebildet mit zwei Transistoren T2, T3, aufgebaut, dessen einer Betriebsspannungsanschluß direkt mit der Betriebsspannungsquelle U_{DD}-U_{SS} und dessen anderer Betriebsspannungsanschluß über einen Transistor T1 mit der Betriebsspannungsquelle U_{DD}-U_{SS} verbunden ist. Die Steuerelektrode des Transistors T1 bildet den Sperreingang s′ des Eingangsverstärkers E, die Verbindung der Steuerelektroden der Transistoren T2 und T3 bilden den Eingang e′ der Eingangstreiberschaltung E und die Verbindung der Hauptelektroden der Transistoren T2 und T3 den Ausgang der Eingangstreiberschaltung E, der mit der jeweiligen Spaltenleitung s verbunden wird.

Wie die schwellwertbehafteten Rückkopplungsglieder R1...Rj schaltungstechnisch realisiert sein können, wird in FIG 5 verdeutlicht:

Die Rückkopplungsglieder R1...Rj sind hier mit einer Kettenschaltung von zwei CMOS-Invertern IN1, IN2 gebildet, wobei die jeweilige Spaltenleitung s mit den Steuerelektroden des den ersten CMOS-Inverter IN1 bildenden komplementären Transistorpaares verbunden ist und der Verbindungspunkt der Hauptelektroden des ersten Transistorpaares mit den Steuerelektroden des den zweiten CMOS-Inverter IN2 bildenden Transistorpaares verbunden ist. Die Verbindung der beiden Hauptelektroden des zweiten Transistorpaares bildet den Ausgang s′ des jeweiligen Rückkopplungsgliedes R1...Rj. Die charakteristische Schaltschwelle eines solchen mit CMOS-Invertern IN1, IN2 gebildeten Rückkopplungsgliedes R ist abhängig von der Schwellspannung U_{TH} des ersten Inverters IN1 und liegt etwa bei 40% der das Rückkopplungsglied R speisenden Betriebsspannung. Demnach liegt für das Rückkopplungsglied R nach FIG 5 die Schaltschwelle bei etwa 2V für eine Betriebsspannung U_{DD}-U_{SS} von 5V.

Alternativ zu der in FIG 5 dargestellten Ausführungsform der Rückkopplungsglieder R1...Rj kann das Rückkopplungsglied R entsprechend FIG 6 mit einem Komparator KOMP, wie er beispielsweise durch einen Operationsverstärker gegeben sein kann, gebildet sein, dessen nichtinvertierender Eingang (+) mit der jeweiligen (Matrix-Eingangsleitung) Spaltenleitung s verbunden ist und dessen invertierender Eingang (-) mit dem einen Anschluß einer Referenzspannungsquelle UR verbunden ist, deren anderer Anschluß mit einem Anschluß der Betriebsspannungsquelle U_{DD}-U_{SS} verbunden ist. Der Ausgang des Komparators KOMP bildet den Anschluß für den Sperreingang s′ der Eingangstreiberschaltung E. Die Schaltschwelle U_{TH} eines solchen Rückkopplungsgliedes R entspricht der Spannungshöhe am invertierenden Eingang (-) des Komparators KOMP.

Die Rückkopplungsglieder R nach FIG 5 oder FIG 6 können ihrerseits rückgekoppelt sein mittels eines hochohmigen Widerstands W, der den Ausgang s′ mit dem Eingang s des Rückkopplungsgliedes R verbindet und der einerseits eine Erhöhung der Verstärkung im Bereich der Schaltschwelle und andererseits eine kleine Hysterese der Schaltschwelle bewirkt. Beide Wirkungen verbessern das Schaltverhalten des Rückkopplungsgliedes R.

Die Ausgangstreiberschaltungen A1...Am können in prinzipiell gleicher Weise wie die Rückkopplungsglieder R nach FIG 5 aufgebaut sein.

Die den Ausgang der Koppelpunktmatrix bildenden Haltespeicher (Latches) L1...Lm sind hinreichend bekannt und müssen deshalb hier nicht näher beschrieben werden.

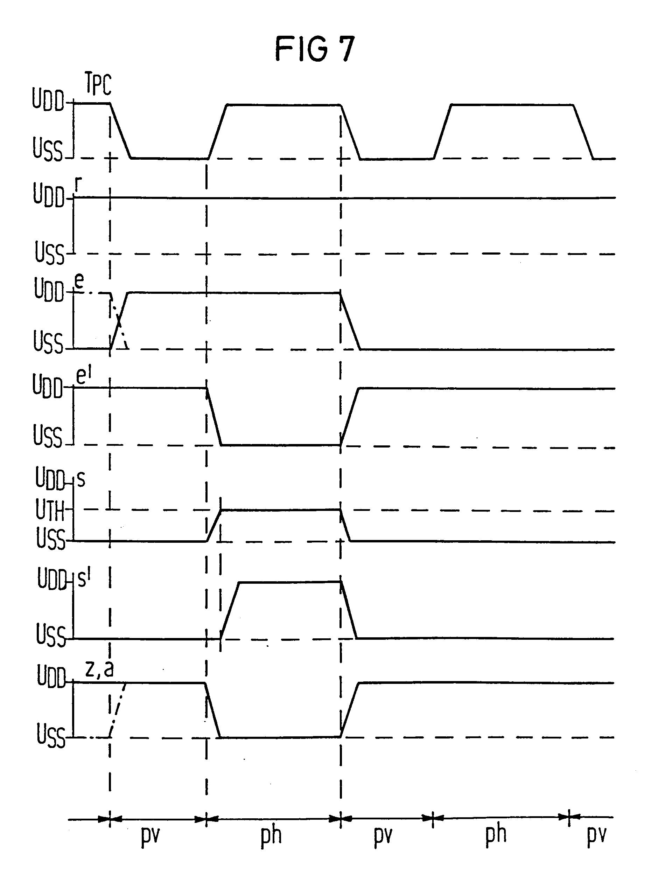

In FIG 7 ist für zwei aufeinanderfolgende Bit-Durchschaltezeitspannen die Übertragung eines "HIGH"-Signals und anschließend eines "LOW"-Signals (vgl. Zeile e) beispielsweise von einem Eingang ej (in FIG 1) zu einem Ausgang ai (in FIG 1) der Koppelpunktmatrix (FIG 1) dargestellt:

Durch ein entsprechendes (im Beispiel "LOW"-Signal), die Steuerelektrode jedes Vorlade-Transistors (Tipc in FIG 3) beaufschlagendes Taktsignal T_{PC} (Zeile T_{PC} in FIG 7) wird bewirkt, daß in jeder Vorladephase pv (in FIG 7, unten) einer durch das Taktsignal T_{PC} in eine solche Vorladephase pv und eine nachfolgende Hauptphase (ph in FIG 7) unterteilten Bitperiode jeder Vorlade-Transistor (Tipc in FIG 3) leitend ist, so daß während der Vorladephase pv die (Matrix-Ausgangsleitungen) Zeilenleitungen z1...zm über den jeweiligen Vorlade-Transistor (Tipc) auf ein zwischen den beiden Betriebspotentialen liegendes Vorladepotential oder auch auf eines der beiden Betriebspotentiale selbst aufgeladen werden (vgl. FIG 7, Zeile z, a, Strich-Punkte-Linie).

In der darauffolgenden Hauptphase ph (siehe FIG 7, unten), werden im Beispiel durch ein "HIGH"-Taktsignal T_{PC} (siehe FIG 7, Zeile T_{PC}) die Vorlade-Transistoren Tipc (in FIG 3) gesperrt; gleichzeitig werden die matrixeingangsseitigen Torschaltungen G1...Gj entriegelt. Dadurch werden die an den Eingangsleitungen der Koppelpunktmatrix e1...ej anliegenden Signale im Beispiel invertiert auf den Eingang e′ der jeweiligen Eingangstreiberschaltung E durchgeschaltet. Ein beispielsweise an der Eingangsleitung ej anliegendes "HIGH"-Signal (vgl. FIG 7, Zeile e) bewirkt also ein "LOW"-Signal am Eingang ej′ der Eingangstreiberschaltung Ej (vgl. FIG 7, Zeile e′).

Erfindungsgemäß lädt die Eingangstreiberschaltung E die mit ihrem Ausgang verbundene (Matrix-Eingangsleitung) Spaltenleitung s für ein am Eingang e′ der Eingangstreiberschaltung E anliegendes (im Beispiel "LOW"-) Signal solange auf (FIG 7, Zeile s), bis der Ladungsfluß durch Sperren des Transistors T1 (in FIG 4) unterbrochen wird. Ein zum Sperren des Transistors T1 geeignetes, im Beispiel "HIGH"-Signal wird dabei durch ein schwellwertbehaftetes Rückkopplungsglied R nach FIG 5 oder nach FIG 6 abgegeben, dessen mit der jeweiligen (Matrix-Eingangsleitung) Spaltenleitung s verbundener Eingang eine vorgegebene Schwellspannung U_{TH} erreicht (vgl. FIG 7, Zeile s, s′)

Die Schwellspannung U_{TH} ist dabei so bemessen, daß ein sicheres Leitendwerden der mit ihrer Steuerelektrode mit der jeweiligen (Matrix-Eingangsleitung) Spaltenleitung s verbundenen Eingangs-Transistoren (Te in FIG 3) gewährleistet ist. Ist nun in einem Koppelelement Kij dessen Schalt-Transistor Tk (in FIG 3) aufgrund eines am Steuereingang r anliegenden (im Beispiel "HIGH"-) Durchschaltesignals (siehe FIG 7, Zeile r) leitend und befindet sich damit der Koppelpunkt KPij im Durchschaltezustand, so wird, jetzt die über das durchgeschaltete Koppelelement Kij mit der (Matrix-Eingangsleitung) Spaltenleitung s verbundene (Matrix-Ausgangsleitung) Zeilenleitung z über die Transistoren Te und Tk zum einen Potential der Betriebsspannungsquelle U_{DD}-U_{SS} (im Beispiel U_{SS}, Masse) hin entladen.

Ein auf der betreffenden (Matrix-Eingangsleitung) Spaltenleitung s anliegender Signalzustand wird dabei über den jeweiligen von seinem Steuereingang r her entriegelten Koppelpunkt invertiert durchgeschaltet (vgl. FIG 7, Zeile s; z,a).

Zum Ende der Hauptphase ph wird das am Ausgang ai der Ausgangstreiberschaltung Ai anstehende "LOW"-Signal (vgl. FIG 7, Zeile z,a) beispielsweise mit dem vom "HIGH"-Zustand in den "L0W"-Zustand führenden Signalwechsel des Vorladetaktsignals T_{PC} in das zugehörige Latch Li übernommen, die Torschaltungen G1...Gj werden verriegelt, d.h. an allen Eingängen e′ der Eingangstreiberschaltungen E stehen im Beispiel "HIGH"-Signale an, wodurch sämtliche Transistoren T3 (in FIG 4) leitend geschaltet werden und dadurch sämtliche (Matrix-Eingangsleitungen) Spaltenleitungen s1..sj entladen werden (vgl. FIG 7, Zeile s), die Rückkopplungsglieder R fallen in den Grundzustand (im Beispiel "LOW"-Zustand) zurück (vgl. FIG 7, Zeile s′), die Transistoren T1 (in FIG 4) werden dadurch leitend geschaltet.

In der nachfolgenden Bit-Durchschaltezeitspanne möge nun gemäß FIG 7 über die betrachtete Eingangsleitung ej ein "LOW"-Signal übertragen werden. In der Vorladephase pv werden zunächst wieder sämtliche (Matrix-Ausgangsleitungen) Zeilenleitungen z1...zm vorgeladen.

In der sich anschließenden Hauptphase ph möge der Schalttransistor Tₖ in dem betrachteten Koppelpunkt (vgl. FIG 3) aufgrund eines (im Beispiel "HIGH"-)Steuersignals r wiederum im Durchschaltezustand sein (vgl. FIG 7, Zeile r). Da an der Eingangsleitung ej ein "LOW"-Signal ansteht (vgl. Zeile e in FIG 7) bleibt die zugehörige (Matrix-Eingangsleitung) Spaltenleitung sj ebenfalls im "LOW"-Zustand mit der Folge, daß der Eingangstransistor Te in dem betrachteten Koppelpunkt (vgl. FIG 3) gesperrt bleibt, die zugehörige (Matrix-Ausgangsleitung) Zeilenleitung zi nicht entladen wird und, der Signalzustand auf der betrachteten Ausgangsleitung ai erhalten bleibt (vgl. FIG 7, Zeile z,a); zum Ende dieser Hauptphase ph wird daher ein "HIGH"-Signal in das Latch Li übernommen.

## Patentansprüche

1. Breitbandsignal-Koppeleinrichtung mit einer Koppelpunkt-Matrix in FET-Technik, deren Eingänge (e) jeweils mit einer Eingangstreiberschaltung (E) versehen sind und deren Ausgänge jeweils mit einer Ausgangstreiberschaltung (A) versehen sein können, wobei die Matrix-Ausgangsleitungen (z) jeweils über eine Vorladeschaltung (PC), die mit einem eine Bitdurchschaltezeitspanne in eine Vorladephase (pv) und die eigentliche Durchschaltephase (ph) unterteilenden Taktsignal (TPC) gesteuert wird, in jeder Vorladephase (pv) auf ein zwischen den beiden Betriebspotentialen (U_{DD},U_{SS}) liegendes Vorladepotential oder auch auf eines der beiden Betriebspotentiale (U_{DD},U_{SS}) selbst aufladbar sind,
**dadurch gekennzeichnet,**
daß der Ausgang (s) der jeweiligen Eingangstreiberschaltung (E) über ein schwellwertbehaftetes Rückkopplungsglied (R) mit einem Sperreingang (s′) der Eingangstreiberschaltung (E) verbunden ist, über den die Umladung des Ausgangs (s) der betreffenden Eingangstreiberschaltung (E) beendet wird.

2. Schaltungsanordnung nach Anspruch 1,
**dadurch gekennzeichnet,**
daß die Eingangstreiberschaltung (E) mit einem Inverterverstärker gebildet ist, in dessen einem Betriebsspannungsanschluß ein Transistor eingefügt ist, dessen Steuerelektrode den Sperreingang der Eingangstreiberschaltung (E) bildet.

3. Schaltungsanordnung nach Anspruch 2,
**dadurch gekennzeichnet,**
daß die Eingangstreiberschaltung (E) in CMOS-Technologie aufgebaut ist.

4. Schaltungsanordnung nach Anspruch 1 bis 3,
**dadurch gekennzeichnet,**
daß das Rückkopplungsglied (R) mit einer Anzahl von CMOS-Inverterverstärkern (IN) gebildet ist.

5. Schaltungsanordnung nach Anspruch 4,
**dadurch gekennzeichnet,**
daß das Rückkopplungsglied (R) mit zwei CMOS-Inverterverstärkern (IN) gebildet ist.

6. Schaltungsanordnung nach Anspruch 1 bis 3,
**dadurch gekennzeichnet,**
daß das Rückkopplungsglied (R) mit einem Komparator (KOMP) gebildet ist, dessen einem Eingang eine Referenzspannung (UR) und dessen anderem Eingang das Ausgangssignal (s) der jeweiligen Eingangstreiberschaltung (E) zugeführt wird.

7. Schaltungsanordnung nach Anspruch 4 bis 6,
**dadurch gekennzeichnet,**
daß das Rückkopplungsglied (R) seinerseits über einen hochohmigen Widerstand (W) rückgekoppelt ist.

## Claims

1. Broadband signal switching network with a switching point matrix employing FET technology, the inputs (e) of which are provided with an input driver circuit (E) in each case and the outputs of which can be provided with an output driver circuit (A) in each case, in which the matrix output lines (z) can be charged in each case by a precharge circuit (PC), which is controlled by a clock signal (TPC) that divides a bit through-connect interval into a precharge phase (pv) and the actual through-connect phase (ph), in each precharge phase (pv) to a precharge potential lying between the two operating potentials (U_{DD}, U_{SS}) or else to one of said two operating potentials (U_{DD}, U_{SS}) itself, characterized in that the output (s) of the respective input driver circuit (E) is connected via a feedback member (R) with a threshold value to an inhibit input (s') of the input driver circuit (E), by means of which the recharging of the output (s) of the respective input driver circuit (E) is terminated.

2. Circuit arrangement according to Claim 1, characterized in that the input driver circuit (E) is formed by an inverter amplifier, into the one operating voltage terminal of which a transistor is inserted whose control electrode forms the inhibit input (s') of the input driver circuit (E).

3. Circuit arrangement according to Claim 2, characterized in that the input driver circuit (E) is constructed in CMOS technology.

4. Circuit arrangement according to Claim 1 to 3, characterized in that the feedback member (R) is formed by a number of CMOS inverter amplifiers (IN).

5. Circuit arrangement according to Claim 4, characterized in that the feedback member (R) is formed by two CMOS inverter amplifiers (IN).

6. Circuit arrangement according to Claim 1 to 3, characterized in that the feedback member (R) is formed by a comparator (KOMP), to the one input of which a reference voltage (UR) is supplied and to the other input of which the output signal (s) of the respective input driver circuit (E) is supplied.

7. Circuit arrangement according to Claim 4 to 6, characterized in that the feedback member (R) is in turn fed back via a high-impedance resistor (W).

## Revendications

1. Dispositif de couplage pour signaux à large bande, comportant une matrice de points de couplage en technique FET, dont les entrées (e) sont chacune munies d'un circuit d'attaque d'entrée (E) et dont les sorties peuvent être chacune munies d'un circuit d'attaque de sortie (A), les lignes de sortie (z) de la matrice pouvant être chargées elles-même, pendant chaque phase de précharge (pv), à un potentiel de précharge situé entre les deux potentiels de service (U_{DD}, U_{SS}), ou également à l'un des deux potentiels de service (U_{DD}, U_{SS}), par l'intermédiaire d'un circuit de précharge (PC), qui est commandé par un signal de cadence (TPC), qui subdivise un intervalle de temps d'interconnexion de bits en une phase de précharge (pv) et en la phase proprement dite d'interconnexion (ph), caractérisé par le fait
que la sortie (s) de chaque circuit d'attaque d'entrée (E) est reliée, par l'intermédiaire d'un circuit de réaction (R) pourvu d'une valeur de seuil, à une entrée de blocage (s') du circuit d'attaque d'entrée (E), par l'intermédiaire de laquelle la charge de la sortie (s) du circuit d'attaque d'entrée concerné (E) est interrompue,

2. Montage suivant la revendication 1, caractérisé par le fait que le circuit d'attaque d'entrée (E) est formé par un amplificateur inverseur, à une borne de tension de service duquel est inséré un transistor, dont l'électrode de commande forme l'entrée de blocage (s') du circuit d'attaque d'entrée (E).

3. Montage suivant la revendication 2, caractérisé par le fait que le circuit d'attaque d'entrée (E) est agencé selon la technologie CMOS.

4. Montage suivant les revendications 1 à 3, caractérisé par le fait que le circuit de réaction (R) est formé d'un certain nombre d'amplificateurs inverseurs CMOS (IN).

5. Montage suivant la revendication 4, caractérisé par le fait que le circuit de réaction (R) est formé par deux circuits inverseurs CMOS (IN).

6. Montage suivant les revendications 1 à 3, caractérisé par le fait que le circuit de réaction (E) est formé par un comparateur (KOMP), à une entrée duquel est envoyé une tension de référence (UR) et à l'autre entrée duquel est envoyé le signal de sortie (s) du circuit d'attaque d'entrée (E).

7. Montage suivant les revendications 4 à 6, caractérisé par le fait que le circuit de réaction (R) est couplé pour sa part par réaction, par l'intermédiaire d'une résistance de forte valeur ohmique (W).
